# EUROPÄISCHE PATENTSCHRIFT

(11) **EP 3 711 903 B1**
(45) Veröffentlichungstag und Bekanntmachung des Hinweises auf die Patenterteilung: **22.01.2025**
(21) Anmeldenummer: 20162445.9
(22) Anmeldetag: 11.03.2020
(51) Int. Cl.: B25F 5/00

(54) **ENERGIESPEICHER MIT PRÄDIKTIONSSTEUERUNG**
ENERGY STORAGE DEVICE WITH PREDICTION CONTROL
ACCUMULATEUR D'ÉNERGIE POURVU DE COMMANDE DE PRÉDICTION

(30) Priorität: 22.03.2019 DE 102019107426
(43) Veröffentlichungstag der Anmeldung: 23.09.2020
(73) Patentinhaber: Einhell Germany AG, 94405 Landau / Isar (DE)
(72) Erfinder: Thannhuber, Markus, 94405 Landau (DE); Sternad, Michael, 4020 Linz (AT)
(74) Vertreter: Hofstetter, Schurack & Partner

(56) Entgegenhaltungen:
- EP-B1- 2 351 182
- WO-A1-2010/049190
- WO-A1-2017/157891
- DE-A1- 102011 005 711
- DE-A1- 102016 104 956
- US-A- 5 182 655
- US-A1- 2003 096 158
- US-A1- 2011 221 396

## Beschreibung

Die vorliegende Erfindung betrifft ein Verfahren zum Betreiben eines Energiespeichers für ein Elektrowerkzeug durch Messen oder Ermitteln eines eindimensionalen oder mehrdimensionalen Zustandsvektors des Energiespeichers und Messen oder Ermitteln eines Verbrauchswerts bezüglich einer Leistungsabgabe des Energiespeichers. Darüber hinaus betrifft die vorliegende Erfindung ein Energiemanagementsystem für einen Energiespeicher eines Elektrowerkzeugs mit einer Messeinrichtung zum Messen eines eindimensionalen oder mehrdimensionalen Zustandsvektors des Energiespeichers und zum Messen eines Verbrauchswerts bezüglich einer Leistungsabgabe des Energiespeichers. Ferner betrifft die vorliegende Erfindung ein Elektrowerkzeug mit einer derartigen Energiespeichereinrichtung.

Unter Elektrowerkzeugen werden hier insbesondere akkubetriebene Handgeräte wie Akkuschrauber, Akkubohrer, Handkreissägen und dergleichen verstanden. Darüber hinaus sollen unter den Begriff Elektrowerkzeuge auch Reinigungsgeräte, Haushaltsgeräte und Gartengeräte fallen.

Energiespeicher sind Batterien oder Akkumulatoren (kurz Akkus), mit denen die Elektrowerkzeuge schnurlos betrieben werden können. Typischerweise besitzen Elektrowerkzeuge austauschbare Akkupacks. Ein derartiges Akkupack umfasst in der Regel mehrere Akkuzellen. Sowohl ein Akkupack als auch eine einzelne Akkuzelle können als Energiespeicher gesehen werden.

Akkupacks, beispielsweise auf Lithium-Ionen-Basis, weisen üblicherweise eine beschränkte Lebensdauer auf, die noch dazu stark von den Bedarfsgewohnheiten eines jeweiligen Benutzers abhängen. Viele Benutzer sind sich dieser Abhängigkeit vom Gebrauch überhaupt nicht bewusst.

Faktoren, welche die Lebenszeit eines Akkupacks beeinflussen, sind unter anderem die Lagertemperatur, die Spannungslage bei Lagerung, Tiefe der Zyklisierung, Geschwindigkeit des Ladeprozesses bei einer bestimmten Temperatur, Beanspruchung im Entladefall, Vibrationsbelastungen, Belastungen durch Stöße und dergleichen. Aufgrund des komplexen Zusammenspiels verschiedener Einflussfaktoren auf die Lebenszeit von Akkupacks ist es also für Benutzer schwer bis gar nicht überschaubar, wie ihr eigenes Verhalten zur Verringerung oder Verlängerung der Lebensdauer von Akkupacks beiträgt.

Bislang verfolgen Batteriemanagementsysteme, die in intelligente Akkupacks integriert sind, häufig den Ansatz, Verbraucher abrupt von der Batterie beziehungsweise dem Akkupack zu trennen, sobald kritische Strom-, Spannungs- oder Temperaturgrenzen überschritten werden. Dies hat zur Folge, dass der Benutzer gegebenenfalls mit noch im Werkstück stehendem/steckendem Werkzeug die Bearbeitung abbrechen muss. Dies stellt mitunter eine recht unkomfortable Situation dar.

Beispielsweise ist aus der Druckschrift US 2003/0096158 A1 ein Batteriepack und ein schnurloses Elektrowerkzeug, das den Batteriepack als Energiequelle nutzt, bekannt. Wenn sich die Batteriespannung über einer ersten Schwelle und unterhalb einer zweiten Schwelle befindet, wird die Rotation des Motors des Elektrowerkzeugs abrupt verlangsamt. Dies ist für den Bediener ein Zeichen dafür, dass die Batterie geladen werden muss.

Des Weiteren beschreibt die Druckschrift US 7 990 109 B2 ein temperaturabhängiges oder polarisationsabhängiges Spannungskompensationssystem. Für den Batteriepack eines Elektrowerkzeugs wird die Dauer bestimmt, während der Strom aus der Batterie gezogen wurde. Eine Abschaltspannung wird in Abhängigkeit von einer Spannungsmessung der Batterie, dem gemessenen Strom und der Stromentnahmezeit eingestellt. Ein Entladesteuermodul beschränkt die Leistung für die Last auf der Basis der eingestellten Abschaltspannung.

Die Druckschrift EP 2 351 182 B1 offenbart eine Energieverbrauchsausgabevorrichtung zur Ausgabe der noch verbleibenden Nutzungsmöglichkeit eines an einen Energiespeicher anschließbaren elektrischen Verbrauchers. Mit Hilfe einer Leistungsvorgabevorrichtung kann der Benutzer die Restnutzungsmöglichkeit vorgeben, so dass der optimale Betriebsmodus des Verbrauchers anhand des Leistungsverbrauchs bei dem aktuellen Betriebsmodus und der Restkapazität des elektrischen Energiespeichers eingestellt wird.

Des Weiteren zeigt die Druckschrift DE 10 2013 213 267 A1 ein Verfahren zum Batteriemanagement, wobei ein in einem Prädiktionszeitraum von der Batterie bereitstellbarer Betrag eines Stroms aus einem in dem Prädiktionszeitraum prädizierten verfügbaren Betrag einer Zustandsgröße ermittelt wird, wobei der prädizierte verfügbare Betrag der Zustandsgröße mittels einer Differenz aus einem bezüglich eines ersten Bezugszeitraums ermittelten zulässigen Betrags der Zustandsgröße und einem bezüglich des ersten Bezugszeitraums ermittelten entnommenen Betrags der Zustandsgröße ermittelt wird.

Die Druckschrift DE 10 2016 104 956 A1 offenbart ein Verfahren zum Betreiben eines Haushaltsgeräts. Eine Steuereinrichtung erfasst den Ladezustand eines Energiespeichers. Eine Betriebszeit wird auf Grund des Ladezustands und einer gewählten Leistungsstufe bestimmt. Wenn die Betriebszeit kleiner als eine Sollbetriebszeit ist, wird die Leistung reduziert. Diese Druckschrift offenbart die Präambel des Anspruches 1.

In dem vorliegenden Dokument wird das Wort "Messen" auch stellvertretend für Messen oder Ermitteln verwendet.

Die Aufgabe der vorliegenden Erfindung besteht darin, ein Elektrowerkzeug mit einem Energiespeicher zuverlässiger betreiben zu können.

Erfindungsgemäß wird diese Aufgabe durch ein Verfahren, ein Energiemanagementsystem und ein Elektrowerkzeug nach einem der unabhängigen Ansprüche gelöst. Vorteilhafte Weiterbildungen der Erfindung ergeben sich aus den Unteransprüchen.

Demnach wird ein Verfahren zum Betreiben eines Energiespeichers für ein Elektrowerkzeug bereitgestellt. Unter dem Energiespeicher wird, wie eingangs erwähnt, insbesondere eine Batterie oder ein Akku beziehungsweise Akkupack verstanden. Unter einem Elektrowerkzeug werden insbesondere die eingangs erwähnten Elektrogeräte, vor allem Akkuschrauber, Akkubohrer, Akku-Handkreissägen, aber auch Akku-Gartengeräte wie etwa Akku-Astsägen und dergleichen subsumiert.

Bei dem Verfahren erfolgt ein Messen eines eindimensionalen oder mehrdimensionalen Zustandsvektors des Energiespeichers. Im einfachsten Fall eines eindimensionalen Zustandsvektors handelt es sich um einen einfachen Zustandswert, der gemessen wird. Ein Beispiel eines solchen Zustandswerts ist der aktuell fließende Strom, die aktuelle Spannung oder die Temperatur des Energiespeichers beziehungsweise Akkupacks. Es können aber auch mehrere Zustandswerte des Energiespeichers (gleichzeitig) gemessen werden. So können etwa die verbleibende Spannung und die Temperatur des Akkupacks gleichzeitig ermittelt werden. Damit ergibt sich aus beiden Werten ein zweidimensionaler Zustandsvektor, der den Zustand des Energiespeichers repräsentiert. Gegebenenfalls werden auch noch mehrere andere Zustandswerte, wie etwa ein Innendruck, ein Innenwiderstand oder ein bestimmtes Elektroden-Potential, gemessen. All diese Zustandswerte ergeben einen mehrdimensionalen Zustandsvektor, der den aktuellen Zustand des Energiespeichers ziemlich deutlich wiedergibt.

Weiterhin erfolgt bei dem erfindungsgemäßen Betriebsverfahren ein Messen eines Verbrauchswerts bezüglich einer Leistungsabgabe des Energiespeichers. Ein solcher Verbrauchswert ist beispielsweise die abgegebene Leistung aus dem Energiespeicher oder der aktuell fließende Strom. Es muss also nicht die tatsächliche Leistung bestimmt werden, die der Energiespeicher abgibt, sondern es können auch entsprechende Teilgrößen wie Ströme und Spannungen ermittelt werden. Gegebenenfalls kann aber auch der aktuell fließende Strom (oder eine andere Größe) als Zustandswert gemessen und daraus der Verbrauchswert (z.B. die Leistung) ermittelt werden.

Ferner erfolgt bei dem erfindungsgemäßen Verfahren ein Bestimmen eines Prädiktionswerts für das Elektrowerkzeug aus dem Zustandsvektor und dem Verbrauchswert mittels eines Modells. Es wird also ein mathematisches Modell benutzt, um einen Wert zum Steuern oder Regeln des Elektrowerkzeugs vorherzusagen oder zu schätzen. Dieser Prädiktionswert betrifft also nicht die Vergangenheit oder Gegenwart, sondern die Zukunft des Betriebs des Energiespeichers beziehungsweise Elektrowerkzeugs. So wird beispielsweise auf der Basis des aktuellen Verbrauchswerts und eines aktuellen Temperaturwerts ein zukünftiger Temperaturwert als Prädiktionswert vorhergesagt. Dies bedeutet, dass für den gegenwärtigen Verbrauch beispielsweise die Temperatur des Akkupacks in den nächsten Sekunden prädiziert werden kann.

Schließlich erfolgt ein Steuern oder Regeln des Elektrowerkzeugs oder Energiespeichers in Abhängigkeit von dem Prädiktionswert. Dies bedeutet, dass das Elektrowerkzeug oder der Energiespeicher mit oder ohne Rückkopplung beeinflusst wird. Während beim Steuern keine Rückkopplung stattfindet, handelt es sich bei der Regelung entsprechend der Systemtheorie um einen geschlossenen Wirkungsablauf, bei dem die Regelgröße im Wirkungsweg des Regelkreises fortlaufend sich selbst beeinflusst. Es kann nicht nur der Energiespeicher selbst, sondern auch das Werkzeug gesteuert beziehungsweise geregelt werden. Dies bedeutet, dass die Leistungsabgabe durch den Energiespeicher direkt von ihm selbst oder aber indirekt durch das Elektrowerkzeug beeinflussbar ist. Das Steuern beziehungsweise Regeln erfolgt anhand des Vorhersage- oder Prädiktionswerts. Wird also beispielsweise vorhergesagt, dass die Temperatur des Akkupacks aufgrund des aktuellen Leistungsverbrauchs in wenigen Sekunden einen unzulässigen Schwellwert überschreiten wird, so kann die Leistungsentnahme bereits zum jetzigen Zeitpunkt, also vor dem tatsächlichen Überschreiten des Schwellwerts, reduziert werden. Der Betrieb des Energiespeichers oder Elektrowerkzeugs wird also nicht (nur) auf Basis eines aktuellen Zustandswerts beeinflusst, sondern auf der Basis eines in der Zukunft liegenden, geschätzten Werts oder geschätzten Werteverlaufs. Auf diese Weise kann beispielsweise verhindert werden, dass eine akkubetriebene Handkreissäge bei sehr hohem Leistungsverbrauch mitten im Schnitt stoppt und beim Weiterschneiden mit einem neu geladenen Akkupack am Unterbrechungspunkt eine unsaubere Schnittkante zu erkennen ist.

Dabei ist vorgesehen, dass der Prädiktionswert eine Restlaufzeit beinhaltet, mit der ein Ende der Restlaufzeit bestimmt wird, und das Steuern (hier wie im Folgenden auch stellvertretend für Regeln) einer Reduzierung der Leistungsabgabe des Energiespeichers, sobald eine Zeitdifferenz von einer aktuellen Zeit bis zu dem Ende der Restlaufzeit einen vorgegebenen Schwellwert unterschreitet, umfasst. Die Restlaufzeit stellt eine Zeitdauer dar, während der der Energiespeicher entsprechend dem gemessenen Verbrauchswert noch Leistung abgeben kann oder während der das Elektrowerkzeug entsprechend dem gemessenen Verbrauchswert noch Leistung entnehmen kann. Unter der Restlaufzeit wird also eine restliche Laufzeitdauer verstanden. Bei der Nutzung der Restlaufzeit kann unterschieden werden, ob diese unterbrechungsfrei oder gegebenenfalls mit Unterbrechungen ist. Wenn die Restlaufzeit beziehungsweise Restlaufzeitdauer bestimmt wurde, kann diese oder ein der Restlaufzeit zu Grunde zu legender Wert über dem vorgegebenen Schwellwert liegen. Zu diesem Zeitpunkt ist noch keine Reduzierung der Leistungsabgabe des Energiespeichers erforderlich. In diesem Fall kann mit der Restlaufzeit ein tatsächliches Ende beziehungsweise ein Endezeitpunkt bestimmt werden. Es bedarf dann keiner erneuten Bestimmung der Restlaufzeit, denn nun kann das Ende der ursprünglich berechneten Restlaufzeit zum Steuern beziehungsweise Regeln verwendet werden. Unterschreitet nämlich die Zeitdifferenz von dem aktuellen Zeitpunkt bis zum Endezeitpunkt der Restlaufzeit den vorgegebenen Schwellwert, so sollte auch dann die Leistungsabgabe des Energiespeichers reduziert werden. Es muss also nicht ständig erneut eine Restlaufzeit berechnet werden. Vielmehr genügt es, wenn zu Beginn einer Leistungsabgabe des Energiespeichers eine Restlaufzeit und gegebenenfalls ein entsprechender Endezeitpunkt der Restlaufzeit für das Regeln beziehungsweise Steuern verwendet wird.

In einer speziellen Ausgestaltung kann der Zustandsvektor, der den Zustand des Energiespeichers beschreibt, einen Zustandswert beinhalten, welcher eine elektrische Spannung an dem Energiespeicher oder einen elektrischen Strom in den oder aus dem Energiespeicher betrifft. Speziell kann die elektrische Spannung die Gesamtspannung an einem Akkupack sein. Alternativ kann es sich bei der elektrischen Spannung auch um eine Einzelspannung einer Akkuzelle handeln. Gegebenenfalls kann der Zustandsvektor eine Vielzahl an Einzelspannungen beinhalten, welche sich jeweils auf eine einzelne Zelle eines Akkupacks beziehen. Anhand dieser Spannungswerte kann sichergestellt werden, dass die Zellchemie während des Betriebs des Energiespeichers nicht beschädigt wird. Insbesondere sollte nämlich eine Zelle nicht unterhalb einer festgelegten Spannung betrieben werden, damit es nicht zu irreversiblen Schäden insbesondere im Hinblick auf die Kapazität des Energiespeichers kommt.

Des Weiteren kann der Zustandsvektor einen Zustandswert beinhalten, der eine Temperatur des Energiespeichers betrifft. Wiederum kann sich die Temperatur auf einen gesamten Akkupack oder auf eine einzelne Zelle eines Akkupacks beziehen. Für die Lebensdauer eines Energiespeichers, z.B. eines Lithium-Ionen-Akkus, ist die Einhaltung einer Temperaturobergrenze von essentieller Bedeutung. Oberhalb einer festgelegten Temperaturgrenze findet in der Regel eine deutlich schnellere Alterung statt. Bei sehr hohen Temperaturen kann eine spontane Zerstörung einsetzen. Unter Umständen ist sogar der Brand oder die Explosion des Energiespeichers möglich. Ist der aktuelle Temperaturwert niedrig, so kann beispielsweise die Steuerung erst später in dem Betrieb des Energiespeichers reduzierend eingreifen als in dem Fall, dass bereits eine höhere Anfangstemperatur des Energiespeichers vorliegt. Gegebenenfalls wird bei sehr niedrigen Temperaturen des Energiespeichers in den nächsten Betriebssekunden überhaupt nicht eingegriffen, während bei schon hoher aktueller Temperatur gegebenenfalls sofort eingegriffen wird.

Des Weiteren kann vorgesehen sein, dass der Zustandsvektor einen Zustandswert beinhaltet, der einen Innendruck des Energiespeichers betrifft. Der Innendruck des Energiespeichers ist ebenfalls ein markanter Parameter bei der Beurteilung des Allgemeinzustands (State of Health) des Energiespeichers. Liegt ein sehr hoher Innendruck des Energiespeichers vor, so besteht die Gefahr, dass sich die Struktur des Energiespeichers verändert und es gegebenenfalls zu einem Kurzschluss kommt. Andererseits können bei zu hohem Druck auch Chemikalien aus dem Energiespeicher austreten, wodurch sich entsprechende Gefahrenpotentiale ergeben.

Entsprechend einer weiteren Ausführungsform kann der Zustandsvektor einen Zustandswert beinhalten, der einen elektrischen Innenwiderstand oder ein Impedanzspektrum des Energiespeichers betrifft. Typischerweise nimmt der Innenwiderstand mit dem Alter des Energiespeichers zu. Der Innenwiderstand ist jedoch maßgeblich verantwortlich für den kalorischen Eintrag bei Stromfluss. Daher ist der Innenwiderstand ein wichtiger Parameter, wenn beispielsweise die Temperatur des Energiespeichers vorhergesagt werden soll. Ist die Leistungsentnahme aus dem Energiespeicher nicht konstant und besitzt steile Leistungsspitzen, so besitzt der Entladestrom entsprechende Wechselanteile. Folglich ist auch das Impedanzspektrum des Energiespeichers von Bedeutung, wenn dessen Temperatur mit einer gewissen Genauigkeit vorhergesagt werden soll. Das Impedanzspektrum kann sich auf zwei und mehr diskrete Frequenzwerte beziehen.

Alternativ oder zusätzlich kann vorgesehen sein, dass der Zustandsvektor einen Zustandswert beinhaltet, der ein oder mehrere Elektrodenpotentiale insbesondere gegen ein Li/Li+-Bezugspotential betrifft. Durch Bezug der Elektrodenpotentiale auf das Li/Li+-Bezugspotential lässt sich der Zustand des Energiespeichers, insbesondere des Lithium-Ionen-Akkus, besonders gut einschätzen. Speziell kann mit dem Li/Li+-Bezugspotential sowohl der Zustand der Anode als auch der der Kathode genauer bestimmt werden, gerade gegenüber dem Fall, dass nur die Gesamtspannung zwischen Anode und Kathode bestimmt wird.

In einer bevorzugten Ausgestaltung des erfindungsgemäßen Verfahrens handelt es sich bei dem Verbrauchswert um einen Stromstärkewert oder einen Leistungswert. Typischerweise wird bei einem Energiespeicher durch das Batteriemanagementsystem die Stromstärke gemessen. Diese kann dann unmittelbar für die Ermittlung des Prädiktionswerts, insbesondere der zukünftigen Temperatur oder zukünftigen Gesamtspannung, verwendet werden. Vielfach wird mit entsprechender Sensorik des Batteriemanagementsystems häufig auch die Spannung des Energiespeichers gemessen. Aus beiden Werten lässt sich dann ein entsprechender Leistungswert ermitteln, welcher wiederum für das Gewinnen des Prädiktionswerts herangezogen werden kann. In aller Regel ist der Leistungswert aussagekräftiger für die Beurteilung der Leistungsabgabe als eine entsprechende Schätzung mithilfe des Stromstärkewerts.

Entsprechend einer Weiterentwicklung des erfindungsgemäßen Verfahrens können zumindest einige der oben geschilderten Verfahrensschritte wiederholt durchgeführt werden. Gegebenenfalls kann die Wiederholung der Verfahrensschritte in gewissen vorgegebenen Zeitabständen (z.B. 1 ms) erfolgen. Unter Umständen kann das Wiederholen auch fortlaufend durchgeführt werden. Dies bedeutet, dass beispielsweise beim Steuern beziehungsweise Regeln des Energiespeichers ständig der Prädiktionswert neu gewonnen wird. Je nach Rechenaufwand liegt dann der Prädiktionswert in entsprechend kurzen Zeitabschnitten jeweils aktualisiert vor. Unter Umständen wird das gesamte Verfahren mehrfach durchgeführt. Somit kann ein zuverlässiger Betrieb auch bei sich ändernden Betriebsarten des Energiespeichers beziehungsweise Elektrowerkzeugs gewährleistet werden.

Der Prädiktionswert kann Teil eines Prädiktionsverlaufs, der bestimmt wird und in Abhängigkeit von dem das Steuern oder Regeln erfolgt, sein, und der Prädiktionsverlauf kann einen zeitlichen Verlauf eines elektrischen Stroms oder einer elektrischen Spannung, eines Ladungszustands, einer Temperatur, eines Elektrodenpotentials, eines Innenwiderstands oder eines Innendrucks des Energiespeichers darstellen. Der Prädiktionsverlauf wird dann beispielsweise für das Ermitteln einer Restlaufzeit des Energiespeichers beziehungsweise des Elektrowerkzeugs benutzt, indem er etwa mit einem Schwellwert verglichen wird.

Bei einer speziellen Ausgestaltung des Verfahrens kann vorgesehen sein, dass der Prädiktionswert derart bestimmt wird, dass eine vorgegebene Mindestspannung des Energiespeichers nicht unterschritten und/oder eine Höchsttemperatur oder ein Innendruck des Energiespeichers nicht überschritten wird. Dies bedeutet, dass bei der Bestimmung des Prädiktionswerts nicht nur eine physikalische Größe überwacht wird, sondern mehrere. Es ist nämlich durchaus denkbar, dass beispielsweise die Restlaufzeit als Prädiktionswert für die Einhaltung der Mindestspannung einen anderen Wert besitzt als für die Einhaltung der Temperatur oder des Innendrucks. Werden die entsprechenden Ergebnisse verknüpft, so kann die Restlaufzeit derart bestimmt werden, dass jede der Bedingungen eingehalten werden kann. Entsprechendes gilt natürlich auch für andere Prädiktionswerte als die Restlaufzeit. Prinzipiell kann ein Prädiktionswert auch eine Gesamtspannung eines Akkupacks, eine Zellspannung einer Einzelzelle des Energiespeichers, eine Temperatur, einen Innendruck, einen Innenwiderstand, definierte Parameter eines Impedanzspektrums, ein spezifisches Elektrodenpotential insbesondere gegen ein Li/Li+-Bezugspotential oder dergleichen betreffen. Das Wort "betreffen" bedeutet im vorliegenden Dokument, dass der jeweilige Wert die entsprechende physikalische Größe direkt sein kann oder diese zumindest indirekt beschreibt.

In einer speziellen Ausgestaltung kann bei dem Reduzieren der Leistungsabgabe des Energiespeichers die Ausgangsspannung oder die Ausgangsstromstärke des Energiespeichers durch ein Energiemanagementsystem des Energiespeichers selbst reduziert werden. Dieses Energiemanagementsystem (auch Batteriemanagementsystem genannt) steuert beziehungsweise regelt hier also den Energiespeicher selbstständig. Entsprechend einer Alternative kann vorgesehen sein, dass das Elektrowerkzeug ein entsprechendes Energiemanagementsystem besitzt, mit dem dann der Energiespeicher indirekt gesteuert beziehungsweise geregelt wird. Besitzt der Energiespeicher das Energiemanagementsystem selbst, so kann jedes Elektrowerkzeug, auch wenn es selbst über kein Energiemanagement verfügt, davon profitieren. Alternativ kann ein Leistungsregler oder Schaltaktuator (z.B. FET) des Elektrowerkzeugs von dem Energiemanagement des Energiespeichers zur Leistungsregelung verwendet werden.

In einer konkreten Ausgestaltung kann der bestimmte Endezeitpunkt der Restlaufzeit an das Elektrowerkzeug übertragen werden, und das Reduzieren der Leistungsabgabe des Energiespeichers wird gesteuert durch das Elektrowerkzeug mittels Reduzieren einer Leistungsaufnahme des Elektrowerkzeugs erzielt. In diesem Fall wird also der Prädiktionswert an das Elektrowerkzeug übermittelt, und dieses nutzt den Prädiktionswert, um das Elektrowerkzeug einschließlich Energiespeicher in gewünschter Weise zu steuern. Dies bedeutet, dass nicht nur die Restlaufzeit, sondern auch andere Prädiktionswerte an das Elektrowerkzeug für dessen Steuerung von dem Energiespeicher zum Elektrowerkzeug übertragen werden können. Gegebenenfalls werden auch nur die Rohdaten im Energiespeicher gemessen und ohne oder nur mit geringer Vorverarbeitung an das Elektrowerkzeug übermittelt. Dort kann dann der Prädiktionswert aus den gegebenenfalls nur geringfügig vorverarbeiteten Rohdaten für die Steuerung des Elektrowerkzeugs ermittelt werden.

Die oben genannte Aufgabe wird erfindungsgemäß auch gelöst durch ein Energiemanagementsystem für einen Energiespeicher eines Elektrowerkzeugs, mit
- einer Messeinrichtung zum Messen oder Ermitteln eines eindimensionalen oder mehrdimensionalen Zustandsvektors des Energiespeichers und zum Messen oder Ermitteln eines Verbrauchswerts bezüglich einer Leistungsabgabe des Energiespeichers,
- einer Recheneinrichtung zum Bestimmen eines Prädiktionswerts für das Elektrowerkzeug oder den Energiespeicher aus dem Zustandsvektor und dem Verbrauchswert mittels eines Modells und
- einer Steuereinrichtung zum Steuern oder Regeln des Elektrowerkzeugs oder Energiespeichers in Abhängigkeit von dem Prädiktionswert, wobei
- der Prädiktionswert eine Restlaufzeit beinhaltet, mit der ein Ende der Restlaufzeit bestimmt wird, und
- die Steuereinrichtung dazu ausgebildet ist, beim Steuern (S5) die Leistungsabgabe des Energiespeichers (1) zu reduzieren, sobald eine Zeitdifferenz von einer aktuellen Zeit bis zu dem Ende der Restlaufzeit einen vorgegebenen Schwellwert unterschreitet.

Die Messeinrichtung besitzt also meist mindestens einen Sensor, in der Regel jedoch mindestens zwei Sensoren. Zum einen muss mindestens ein Zustandswert des Energiespeichers für den Zustandsvektor gemessen oder ermittelt werden und zum anderen muss mindestens der genannte Verbrauchswert gemessen werden. Für beide Messungen sind geeignete Sensoren vorzusehen, die die entsprechenden physikalischen Werte messen. Vorzugsweise sind mehr als zwei Sensoren vorgesehen, die mehr aktuelle Zustandswerte (mehrdimensionaler Zustandsvektor) und gegebenenfalls auch mehrere Verbrauchswerte erfassen können.

Die Recheneinrichtung kann einen oder mehrere Prozessoren beinhalten, um den Prädiktionswert als Ausgangswert auf der Basis des Zustandsvektors und des Verbrauchswerts als Eingangswerte zu ermitteln. In dieser Recheneinrichtung ist das genannte Modell implementiert, mit dem die gewünschte Funktion des Bestimmens des Prädiktionswerts aus den Eingangswerten realisierbar ist. Die Recheneinrichtung kann auch künstliche Intelligenz und insbesondere ein neuronales Netz oder dergleichen enthalten, welches vor Inbetriebnahme des Energiespeichers gegebenenfalls auch individuell trainiert wurde.

Die oben im Zusammenhang mit dem erfindungsgemäßen Verfahren geschilderten Vorteile und Variationsmöglichkeiten lassen sich auch als funktionelle Merkmale mit entsprechenden Mitteln in dem erfindungsgemäßen Energiemanagementsystem implementieren.

Speziell kann auch ein Energiespeicher mit einem Energiemanagementsystem der soeben genannten Art bereitgestellt werden. Insbesondere kann es sich bei diesem Energiespeicher um einen intelligenten Akkupack handeln. Dieser besitzt dann beispielsweise innerhalb eines Gehäuses nicht nur Speicher- beziehungsweise Energiezellen (vorzugsweise Lithium-Ionen-Zellen), sondern auch das Energiemanagementsystem.

Zudem kann erfindungsgemäß auch ein Elektrowerkzeug mit einem Energiespeicher obiger Bauart bereitgestellt werden. Insbesondere kann der Energiespeicher als Akkupack lösbar an dem Elektrowerkzeug befestigt sein. Hierdurch lässt sich der erfindungsgemäße Energiespeicher zusammen mit unterschiedlichen Elektrowerkzeugen nutzen.

Die vorliegende Erfindung wird nun anhand der beigefügten Zeichnungen näher erläutert, in denen zeigen:
- Fig. 1: ein schematisches Blockdiagramm eines Ausführungsbeispiels eines erfindungsgemäßen Verfahrens; und
- Fig. 2: eine prinzipielle Skizze eines erfindungsgemäßen Energiespeichers.

Die nachfolgend näher geschilderten Ausführungsbeispiele stellen bevorzugte Ausführungsformen der vorliegenden Erfindung dar.

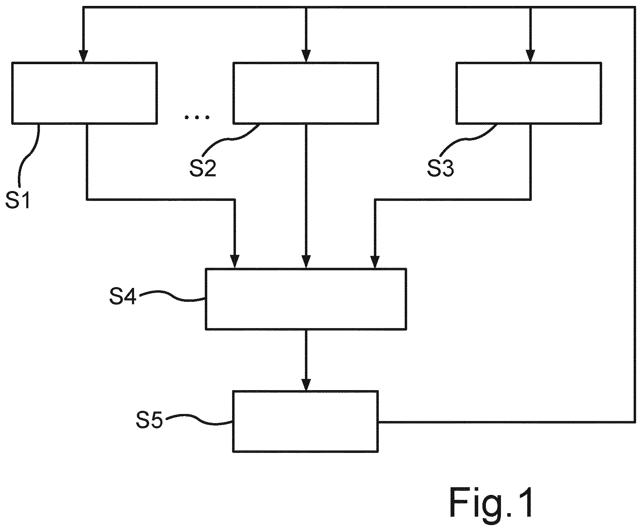

Ein Elektrowerkzeug wie etwa eine akkubetriebene Handkreissäge sollen zuverlässiger beziehungsweise komfortabler betrieben werden können. Dazu wird entsprechend Fig. 1 ein Ausführungsbeispiel eines Verfahrens zum Betrieb eines Energiespeichers des Elektrowerkzeugs zur Verfügung gestellt. In einem Schritt S1 wird ein erster Zustandswert des Energiespeichers gemessen beziehungsweise erfasst. In einem optionalen zweiten Schritt S2 wird ein zweiter Zustandswert des Energiespeichers gemessen beziehungsweise erfasst. Gegebenenfalls werden noch weitere Zustandswerte des Energiespeichers gemessen. Jeder Zustandswert wird typischerweise mit einem eigenen Sensor gemessen beziehungsweise erfasst (im vorliegenden Dokument wird unter "messen" auch "erfassen" verstanden, bei dem unter Umständen ein Zustandswert nur datentechnisch aufgenommen wird). Aus einem einzelnen Zustandswert ergibt sich ein eindimensionaler Zustandsvektor. Aus mehreren Zustandswerten ergibt sich entsprechend ein mehrdimensionaler Zustandsvektor. Typischerweise betreffen die Zustandswerte einen Lade- oder Entladestrom, eine Spannung oder eine Temperatur. Diese Größen können entweder auf eine einzelne Zelle oder auf einen Pack von mehreren Zellen bezogen werden. So kann der Strom, die Spannung oder die Temperatur einer einzelnen Zelle gemessen werden. Alternativ oder zusätzlich können auch der Strom und die Spannung oder die Temperatur eines Zellpacks (auch Akkupack genannt) gemessen werden. Entsprechend wird unter dem Energiespeicher entweder die einzelne Zelle oder der Zellpack verstanden.

Alternativ oder zusätzlich können auch andere physikalische Größen des Energiespeichers für den Zustandsvektor gemessen werden. Dies sind beispielsweise der Innendruck, der elektrische Innenwiderstand, das Impedanzspektrum, eines oder mehrere Elektrodenpotentiale oder dergleichen. Gegebenenfalls kann auch die Temperatur einer Elektronikkomponente (z.B. eines Leistungshalbleiters) als Zustandswert erfasst werden. All die gemessenen Zustandswerte des Zustandsvektors können als Eingangsgrößen für das weitere Verfahren genutzt werden.

Zusätzlich zu dem Messen oder Ermitteln des ein- oder mehrdimensionalen Zustandsvektors gemäß den Schritten S1 und S2 erfolgt in Schritt S3 ein Messen oder Ermitteln eines Verbrauchswerts bezüglich einer Leistungsabgabe des Energiespeichers. Dieser Verbrauchswert kann beispielsweise die Stromstärke und gegebenenfalls auch die elektrische Spannung des Energiespeichers sein. Aus dem Strom kann die Leistungsabgabe geschätzt werden. Aus Strom und Spannung kann die Leistungsabgabe durch Multiplikation berechnet werden.

In einem anschließenden Schritt S4 erfolgt ein Bestimmen eines Prädiktionswerts für das Elektrowerkzeug oder den Energiespeicher. Dieser Prädiktionswert wird aus den Werten bestimmt, die mit den Schritten S1 bis S3 gemessen beziehungsweise erfasst oder ermittelt wurden. Insbesondere wird der Prädiktionswert aus dem Zustandsvektor und dem Verbrauchswert mittels eines Modells bestimmt. Dies bedeutet, dass für die Vorhersage des Betriebs des Elektrowerkzeugs beziehungsweise Energiespeichers der aktuelle Zustand des Energiespeichers, aber auch der momentane Leistungsverbrauch berücksichtigt wird. Auf Basis dieser Größen lässt sich der Zustand des Energiespeichers beziehungsweise eine oder mehrere physikalische Größen des Energiespeichers voraussagen.

Bei dem Prädiktionswert kann es sich beispielsweise um die Restlaufzeit handeln, die u.a. aus der aktuellen Leistungsabgabe berechnet wird. Besitzt der Energiespeicher beispielsweise noch eine bestimmte Ladung, so kann aus der aktuellen Leistungsabgabe berechnet werden, wie lange diese Leistungsabgabe noch erfolgen kann, bis ein bestimmter Grenzwert (z.B. die Entladeschlussspannung oder eine Maximaltemperatur) unter- oder überschritten ist. Aus dieser Zeitdauer kann dann gegebenenfalls auch ein Zeitpunkt ausgehend vom aktuellen Zeitpunkt berechnet werden. Wenn die berechnete Zeitdauer, d.h. die Restlaufzeit, beispielsweise unter 5 s liegt, kann dies dem Bediener haptisch dadurch kenntlich gemacht werden, dass die Leistungsabgabe des Energiespeichers kurzfristig oder über die gesamte Restlaufzeit reduziert wird. Dies bedeutet, dass in einem Schritt S5 ein Steuern oder Regeln des Elektrowerkzeugs oder Energiespeichers in Abhängigkeit von dem Prädiktionswert erfolgt, der in Schritt S4 ermittelt wurde.

Anstelle der Restlaufzeit kann als Prädiktionswert auch ein anderer physikalischer Wert wie etwa die Temperatur im Inneren einer Zelle, eine Zellspannung, ein Anodenpotential, ein Kathodenpotential, ein Innendruck einer Zelle oder dergleichen mittels eines Modells bestimmt werden. Falls sich bei der aktuellen Leistungsabgabe ein Gleichgewicht bestimmter Parameter des Energiespeichers einstellt, so kann ein entsprechender Gleichgewichtswert den Prädiktionswert darstellen. Erreicht der Energiespeicher beispielsweise bei einer bestimmten Leistungsabgabe im Gleichgewicht eine bestimmte Zelltemperatur, so kann der Prädiktionswert diese (maximale) Zelltemperatur sein. Ähnliches gilt für den Innendruck der Zelle.

Alternativ kann der Prädiktionswert auch Teil eines Prädiktionsverlaufs sein. Der Prädiktionsverlauf stellt eine Vielzahl an Prädiktionswerten über der Zeit dar. In einer Ausführungsform kann beispielsweise der Verlauf der Zellspannung als Prädiktionsverlauf bei der aktuellen Leistungsabgabe bestimmt werden. Aus dem Verlauf der Zellspannung kann dann beispielsweise auf eine Restlaufzeit bei gleichbleibender Leistungsabgabe geschlossen werden. Unterschreitet nämlich die prädizierte Zellspannung beispielsweise die Entladeschlussspannung, so wäre das Ende der Restlaufzeit erreicht. Ähnliches gilt beispielsweise für den Innendruck, die Zelltemperatur, das Anodenpotential und das Kathodenpotential des Energiespeichers. Das Modell zum Bestimmen des Prädiktionswerts beziehungsweise des Prädiktionsverlaufs kann auf künstlicher Intelligenz beruhen. Insbesondere kann beispielsweise ein neuronales Netz verwendet werden, um den Prädiktionswert beziehungsweise Prädiktionsverlauf aus mehreren Eingangsgrößen, nämlich dem einen oder den mehreren Zustandswerten (Zustandsvektor) und dem einen oder den mehreren Verbrauchswerten, zu ermitteln. Dabei kann das neuronale Netz mit zahlreichen Datensätzen angelernt werden. Die Verwendung eines neuronalen Netzes hat den Vorteil, dass es ohne großen Aufwand exakt an den bestimmten Typ eines Energiespeichers angepasst werden kann. Es liefert dann für diesen Typ von Energiespeicher stets optimale Prädiktionswerte.

Optional werden nicht nur ein Verbrauchswert, sondern eine zeitliche Reihe von Verbrauchswerten (Belastungsprofil) für die Leistungsabgabe des Energiespeichers gemessen. Auch aus einem derartigen Belastungsprofil kann insbesondere mittels eines neuronalen Netzes eine Vorhersage in Form eines Prädiktionswerts oder Prädiktionsverlaufs bestimmt werden. Auf diese Weise können auch Schwankungen bei der Leistungsabgabe für die Prädiktion berücksichtigt werden.

Das Steuern oder Regeln des Elektrowerkzeugs oder Energiespeichers in Abhängigkeit von dem Prädiktionswert beziehungsweise Prädiktionsverlauf beinhaltet ein Reduzieren der Leistungsabgabe.

Gegebenenfalls kann der Lade- oder Entladestrom auch komplett unterbrochen werden. In einer Ausführungsform kann auch die Leistungsabgabe in Abhängigkeit von beispielsweise dem Vorschub einer Kreissäge oder eines Schlagbohrers geregelt werden.

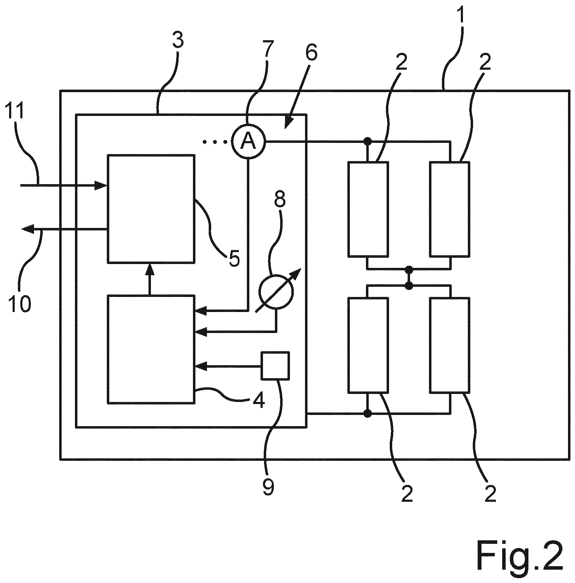

In Fig. 2 ist ein Energiespeicher 1 schematisch dargestellt. Bei dem Energiespeicher 1 kann es sich beispielsweise um einen austauschbaren Akkupack eines Elektrowerkzeugs handeln. Der Energiespeicher 1 besitzt hier symbolisch vier Speicherzellen 2. Die Speicherzellen 2 sind im vorliegenden Beispiel stellvertretend für beliebige andere Schaltungen paarweise parallelgeschaltet, wobei die Parallelschaltungen in Serie geschaltet sind. So sind beispielsweise Strommessungen in allen Zweigen für jede einzelne Speicherzelle 2 möglich. Der Energiespeicher 1 besitzt außerdem ein Energiemanagementsystem 3. Es dient zum Steuern beziehungsweise Regeln des Energiespeichers 1. Dazu besitzt das Energiemanagementsystem 3 zahlreiche Funktionen und insbesondere diejenigen, die im Zusammenhang mit Fig. 1 erläutert wurden. Die einzelnen Funktionen können optional sein. Speziell kann das Energiemanagementsystem 3 die Leistungsabgabe des Energiespeichers 1 steuern oder regeln. Beispielsweise kann an einem oder mehreren bzw. jedem der Speicherzellen jeweils eine Temperatur, ein Druck und/ oder ein Storm gemessen werden. Ferner kann an jeder der Parallelschaltungen der Speicherzellen eine jeweilige Teilspannung und an der Serienschaltung der Parallelschaltungen eine Gesamtspannung des Energiespeichers gemessen werden.

Das Energiemanagementsystem 3 besitzt hier eine Recheneinrichtung 4 und eine Steuereinrichtung 5. Außerdem besitzt das Energiemanagementsystem 3 eine Messeinrichtung 6 zum Messen des mindestens einen Zustandswerts und des mindestens einen Verbrauchswerts. Beispielsweise umfasst die Messeinrichtung 6 einen Stromstärkesensor 7 zum Messen einer Stromstärke, die in oder aus den Speicherzellen 2 fließt. Darüber hinaus kann die Messeinrichtung 6 auch beispielsweise einen Spannungssensor 8 aufweisen, um eine Gesamtspannung mehrerer Speicherzellen 2 oder eine Einzelspannung einer Speicherzelle 2 zu messen. Darüber hinaus kann die Messeinrichtung auch beispielsweise einen Temperatursensor 9 aufweisen, um die Temperatur im Gehäuse des Energiespeichers 1, an einer Speicherzelle 2 oder in einer Speicherzelle 2 zu messen. Es können zahlreiche weitere Sensoren zum Erfassen physikalischer Größen als Zustandswerte oder Verbrauchswerte in der Messeinrichtung 6 vorgesehen sein. Die Sensoren 7, 8, 9 der Messeinrichtung 6 liefern entsprechende Messwerte an die Recheneinrichtung 4.

Die Recheneinrichtung 4 besitzt ein mathematisches Modell beziehungsweise einen Algorithmus (z.B. basierend auf einem neuronalen Netz), mit dem aus den Eingangsgrößen (Zustandswert(e) und Verbrauchswert(e)) ein Prädiktionswert beziehungsweise Prädiktionsverlauf bestimmt wird.

Der Prädiktionswert beziehungsweise der Prädiktionsverlauf wird an die Steuereinrichtung 5 übermittelt. Die Steuereinrichtung 5 steuert beziehungsweise regelt in einer Ausführungsform den Energiespeicher 1 anhand des Prädiktionswerts selbst. Speziell kann die Steuereinrichtung 5 die Leistungsabgabe an einem Ausgang 10 der Steuereinrichtung 5 beziehungsweise des Energiespeichers 1 reduzieren, (kurz) unterbrechen und so weiter.

Bei einer anderen Ausführungsform produziert die Steuereinrichtung 5 aus dem Prädiktionswert der Recheneinrichtung 4 ein Steuer- beziehungsweise Regelsignal am Ausgang 10, um etwa das Elektrowerkzeug zu steuern oder zu regeln. So ist es denkbar, dass das Elektrowerkzeug aufgrund des Steuersignals weniger Leistung von dem Energiespeicher 1 anfordert. Gegebenenfalls wird der Prädiktionswert der Recheneinrichtung 4 durch die Steuereinrichtung 5 auch nur unverändert an das Elektrowerkzeug übertragen. In diesem Fall besitzt die Steuereinrichtung nicht (nur) eine Steuerfunktionalität, sondern (auch) eine Schnittstellenfunktionalität zur Datenübertragung.

Optional kann die Steuereinrichtung 5 einen Eingang 11 besitzen, der ebenfalls wie der Ausgang 10 für Leistungs- und/oder Datensignale ausgelegt sein kann. Beispielsweise steuert die Steuereinrichtung 5 den Ladestrom über den Eingang 11 für den Energiespeicher 1. Diese Steuerung erfolgt vorzugsweise in Abhängigkeit von dem Prädiktionswert der Recheneinrichtung 4. Gegebenenfalls kann der Eingang 11 aber auch dazu dienen, ein Steuersignal von dem Elektrowerkzeug aufzunehmen und den Lade- oder Entladevorgang des Energiespeichers 1 in Abhängigkeit von diesem Steuersignal zu beeinflussen. Auf diese Weise kann die Steuereinrichtung 5 beispielsweise den Entladestrom in Abhängigkeit von dem Typ des Elektrowerkzeugs und in Abhängigkeit von dem Detektionswert steuern beziehungsweise regeln.

Erfindungsgemäß kann somit eine verbesserte Steuerung insbesondere im Leistungsgrenzfall oder in der Nähe des Leistungsgrenzfalls realisiert werden, um etwa die abgegebene Akkupack-Spannung entsprechend der Leistungsgrenzsituation zu reduzieren. Speziell kann beispielsweise ein zeitaufgelöster kalorischer Steuerungsmechanismus bereitgestellt werden, mit dem zu jedem Zeitpunkt die echte Lastsituation innerhalb der Zellen rechnerisch berücksichtigt werden kann. Geraten die Zellen z.B. an ihre Leistungsgrenze, so besteht unter derartigen Bedingungen die Möglichkeit, die Leistungsabgabe des Packs an die Lastsituation innerhalb der Zellen anzupassen, indem die Abgabespannung an den Packkontakten gezielt reduziert wird. Durch die reduzierte angebotene Packspannung reduziert sich für üblich ebenfalls die Stromaufnahme in den damit betriebenen Elektrowerkzeugen. Dies führt natürlich zu einem Leistungsabfall am Werkzeug, erlaubt es aber, die Arbeit fortzuführen. Ein auf diese Art und Weise gesteuertes Elektrowerkzeug gibt dem Benutzer ein haptisches Feedback (z.B. Drehzahlrückgang) und erlaubt ihm, die abgeforderte Leistung z.B. durch ein Reduzieren des Anpressdrucks anzupassen und den Arbeitsvorgang dabei trotzdem ohne Unterbrechung fortzuführen. Dies ist insbesondere dann wichtig, wenn z.B. trennende Schnitte ohne Unterbrechung auszuführen sind, da beispielsweise das Schnittbild durch eine Unterbrechung des Arbeitsvorgangs leidet.

Die technische Realisierung der Spannungsanpassung kann beispielsweise durch eine Pulsweitenmodulation erfolgen. Es kann aber auch ein Linearregler oder dergleichen verwendet werden. Alternativ kann auch das Motorsteuergerät des Elektrowerkzeugs dafür eingesetzt werden, zur Leistungsreduktion entsprechend weniger Strom aufzunehmen. In diesem Fall ist also eine entsprechende Kommunikation zwischen dem Energiespeicher und dem Verbraucher notwendig.

### BEZUGSZEICHENLISTE:

- 1: Energiespeicher
- 2: Speicherzelle
- 3: Energiemanagementsystem
- 4: Recheneinrichtung
- 5: Steuereinrichtung
- 6: Messeinrichtung
- 7: Sensor
- 8: Sensor
- 9: Sensor
- 10: Ausgang
- 11: Eingang
- S1: erster Schritt
- S2: zweiter Schritt
- S3: dritter Schritt
- S4: vierter Schritt
- S5: fünfter Schritt

## Patentansprüche

1. Verfahren zum Betreiben eines Energiespeichers (1) für ein Elektrowerkzeug durch
- Messen oder Ermitteln (S1, S2) eines eindimensionalen oder mehrdimensionalen Zustandsvektors des Energiespeichers (1),
- Messen oder Ermitteln (S3) eines Verbrauchswerts bezüglich einer Leistungsabgabe des Energiespeichers (1),
- Bestimmen (S4) eines Prädiktionswerts für das Elektrowerkzeug oder den Energiespeicher (1) aus dem Zustandsvektor und dem Verbrauchswert mittels eines Modells und
- Steuern oder Regeln (S5) des Elektrowerkzeugs oder Energiespeichers (1) in Abhängigkeit von dem Prädiktionswert;
**dadurch gekennzeichnet, dass**
- der Prädiktionswert ein Ende einer Restlaufzeit beinhaltet und das Steuern (S5) ein Reduzieren der Leistungsabgabe des Energiespeichers (1), sobald eine Zeitdifferenz von einer aktuellen Zeit bis zu dem Ende der Restlaufzeit einen vorgegebenen Schwellwert unterschreitet, umfasst.

2. Verfahren nach Anspruch 1,
**dadurch gekennzeichnet, dass**
der Zustandsvektor einen Zustandswert beinhaltet, der eine elektrische Spannung an dem Energiespeicher (1) oder einen elektrischen Strom in den oder aus dem Energiespeicher (1) betrifft.

3. Verfahren nach einem der vorhergehenden Ansprüche,
**dadurch gekennzeichnet, dass**
der Zustandsvektor einen Zustandswert beinhaltet, der eine Temperatur des Energiespeichers (1) betrifft.

4. Verfahren nach einem der vorhergehenden Ansprüche,
**dadurch gekennzeichnet, dass**
der Zustandsvektor einen Zustandswert beinhaltet, der einen Innendruck des Energiespeichers (1) betrifft.

5. Verfahren nach einem der vorhergehenden Ansprüche,
**dadurch gekennzeichnet, dass**
der Zustandsvektor einen Zustandswert beinhaltet, der einen elektrischen Innenwiderstand oder ein Impedanzspektrum des Energiespeichers (1) betrifft.

6. Verfahren nach einem der vorhergehenden Ansprüche,
**dadurch gekennzeichnet, dass**
der Zustandsvektor einen Zustandswert beinhaltet, der ein oder mehrere Elektrodenpotentiale insbesondere gegen ein Li/Li+-Bezugspotential betrifft.

7. Verfahren nach einem der vorhergehenden Ansprüche,
**dadurch gekennzeichnet, dass**
der Verbrauchswert ein Stromstärkewert oder ein Leistungswert ist.

8. Verfahren nach einem der vorhergehenden Ansprüche,
**dadurch gekennzeichnet, dass**
zumindest einige der Verfahrensschritte (S1 bis S5) wiederholt durchgeführt werden.

9. Verfahren nach einem der vorhergehenden Ansprüche,
**dadurch gekennzeichnet, dass**
der Prädiktionswert Teil eines Prädiktionsverlaufs, der bestimmt wird und in Abhängigkeit von dem das Steuern oder Regeln (S5) erfolgt, ist, und der Prädiktionsverlauf einen zeitlichen Verlauf einer elektrischen Spannung, eines Ladungszustands, einer Temperatur, eines Elektrodenpotentials, eines Innenwiderstands oder eines Innendrucks des Energiespeichers (1) darstellt.

10. Verfahren nach einem der vorhergehenden Ansprüche,
**dadurch gekennzeichnet, dass**
bei dem Reduzieren der Leistungsabgabe des Energiespeichers (1) die Ausgangsspannung oder die Ausgangsstromstärke des Energiespeichers durch ein Energiemanagementsystem (3) des Energiespeichers (1) selbst reduziert wird.

11. Verfahren nach einem der Ansprüche 1 bis 9,
**dadurch gekennzeichnet, dass**
das bestimmte Ende der Restlaufzeit an das Elektrowerkzeug übertragen wird und das Reduzieren der Leistungsabgabe des Energiespeichers (1) gesteuert durch das Elektrowerkzeug mittels Reduzieren einer Leistungsaufnahme des Elektrowerkzeugs erzielt wird.

12. Energiemanagementsystem (3) für einen Energiespeicher (1) eines Elektrowerkzeugs, mit
- einer Messeinrichtung (6) zum Messen eines eindimensionalen oder mehrdimensionalen Zustandsvektors des Energiespeichers (1) und zum Messen eines Verbrauchswerts bezüglich einer Leistungsabgabe des Energiespeichers (1),
einer Recheneinrichtung (4) zum Bestimmen eines Prädiktionswerts für das Elektrowerkzeug oder den Energiespeicher (1) aus dem Zustandsvektor und dem Verbrauchswert mittels eines Modells und
- einer Steuereinrichtung (5) zum Steuern oder Regeln des Elektrowerkzeugs oder Energiespeichers (1) in Abhängigkeit von dem Prädiktionswert,
**dadurch gekennzeichnet, dass**
- der Prädiktionswert ein Ende einer Restlaufzeit beinhaltet und
- die Steuereinrichtung dazu ausgebildet ist, beim Steuern (S5) die Leistungsabgabe des Energiespeichers (1) zu reduzieren, sobald eine Zeitdifferenz von einer aktuellen Zeit bis zu dem Ende der Restlaufzeit einen vorgegebenen Schwellwert unterschreitet.

13. Energiespeicher (1) mit einem Energiemanagementsystem (3) nach Anspruch 12.

14. Elektrowerkzeug mit einem Energiespeicher (1) nach Anspruch 13.

## Claims

1. A method for operating an energy storage (1) for an electric tool by
- measuring or ascertaining (S1, S2) a one-dimensional or multi-dimensional state vector of the energy storage (1),
- measuring or ascertaining (S3) a consumption value with respect to a power output of the energy storage (1),
- determining (S4) a prediction value for the electric tool or the energy storage (1) from the state vector and the consumption value by means of a model, and
- controlling or regulating (S5) the electric tool or energy storage (1) depending on the prediction value;
**characterized in that**
- the prediction value includes an end of a remaining runtime, and controlling (S5) includes reducing the power output of the energy storage (1) as soon as a time difference from a current time up to the end of the remaining runtime falls below a preset threshold value.

2. The method according to claim 1,
**characterized in that**
the state vector includes a state value, which relates to an electrical voltage on the energy storage (1) or an electrical current into the or from the energy storage (1).

3. The method according to any one of the preceding claims,
**characterized in that**
the state vector includes a state value, which relates to a temperature of the energy storage (1).

4. The method according to any one of the preceding claims,
**characterized in that**
the state vector includes a state value, which relates to an internal pressure of the energy storage (1).

5. The method according to any one of the preceding claims,
**characterized in that**
the state vector includes a state value, which relates to an electrical internal resistance or an impedance spectrum of the energy storage (1).

6. The method according to any one of the preceding claims,
**characterized in that**
the state vector includes a state value, which relates to one or more electrode potentials in particular against a Li/Li+ reference potential.

7. The method according to any one of the preceding claims,
**characterized in that**
the consumption value is a current strength value or a power value.

8. The method according to any one of the preceding claims
**characterized in that**
at least some of the method steps (S1 to S5) are repeatedly performed.

9. The method according to any one of the preceding claims,
**characterized in that**
the prediction value is part of a prediction course, which is determined and is effected depending on controlling or regulating (S5), and the prediction course represents a temporal course of an electrical voltage, a state of charge, a temperature, an electrode potential, an internal resistance or an internal pressure of the energy storage (1).

10. The method according to any one of the preceding claims,
**characterized in that**
in reducing the power output of the energy storage (1), the output voltage or the output current strength of the energy storage is reduced by an energy management system (3) of the energy storage (1) itself.

11. The method according to any one of claims 1 to 9,
**characterized in that**
the determined end of the remaining runtime is transferred to the electric tool and reducing the power output of the energy storage (1) is achieved controlled by the electric tool by means of reducing a power input of the electric tool.

12. An energy management system (3) for an energy storage (1) of an electric tool, comprising
- a measuring device (6) for measuring a one-dimensional or multi-dimensional state vector of the energy storage (1) and for measuring a consumption value with respect to a power output of the energy storage (1), a computing device (4) for determining a prediction value for the electric tool or the energy storage (1) from the state vector and the consumption value by means of a model, and
- a control device (5) for controlling or regulating the electric tool or energy storage (1) depending on the prediction value,
**characterized in that**
- the prediction value includes an end of a remaining runtime, and
- the control device is formed to reduce the power output of the energy storage (1) in controlling (S5) as soon as a time difference from a current time up to an end of the remaining runtime falls below a preset threshold value.

13. An energy storage (1) with an energy management system (3) according to claim 12.

14. An electric tool with an energy storage (1) according to claim 13.

## Revendications

1. Procédé de fonctionnement d'un accumulateur d'énergie (1) destiné à un outil électrique, ledit procédé comprenant les étapes suivantes
- mesurer ou déterminer (S1, S2) un vecteur d'état unidimensionnel ou multidimensionnel de l'accumulateur d'énergie (1),
- mesurer ou déterminer (S3) une valeur de consommation par rapport à une puissance délivrée de l'accumulateur d'énergie (1),
- déterminer (S4) une valeur de prédiction pour l'outil électrique ou l'accumulateur d'énergie (1) à partir du vecteur d'état et de la valeur de consommation à l'aide d'un modèle et
- commander ou réguler (S5) l'outil électrique ou l'accumulateur d'énergie (1) en fonction de la valeur de prédiction ;
**caractérisé en ce que**
- la valeur de prédiction inclut une fin de durée de marche restante et la commande (S5) comprend la réduction de la puissance délivrée de l'accumulateur d'énergie (1) dès qu'une différence de temps entre un instant actuel et la fin de durée de marche restante tombe au-dessous d'une valeur seuil spécifiée.

2. Procédé selon la revendication 1,
**caractérisé en ce que**
le vecteur d'état contient une valeur d'état qui se rapporte à une tension électrique au niveau de l'accumulateur d'énergie (1) ou à un courant électrique entrant dans l'accumulateur d'énergie (1) ou sortant de celui-ci.

3. Procédé selon l'une des revendications précédentes,
**caractérisé en ce que**
le vecteur d'état contient une valeur d'état qui se rapporte à une température de l'accumulateur d'énergie (1) .

4. Procédé selon l'une des revendications précédentes,
**caractérisé en ce que**
le vecteur d'état contient une valeur d'état qui se rapporte à une pression interne de l'accumulateur d'énergie (1).

5. Procédé selon l'une des revendications précédentes,
**caractérisé en ce que**
le vecteur d'état contient une valeur d'état qui se rapporte à une résistance électrique interne ou à un spectre d'impédance de l'accumulateur d'énergie (1).

6. Procédé selon l'une des revendications précédentes,
**caractérisé en ce que**
le vecteur d'état contient une valeur d'état qui se rapporte à un ou plusieurs potentiels d'électrode, en particulier par rapport à un potentiel de référence Li/Li+.

7. Procédé selon l'une des revendications précédentes,
**caractérisé en ce que**
la valeur de consommation est une valeur d'intensité de courant ou une valeur de puissance.

8. Procédé selon l'une des revendications précédentes,
**caractérisé en ce que**
au moins certaines des étapes de procédé (S1 à S5) sont exécutées de manière répétée.

9. Procédé selon l'une des revendications précédentes,
**caractérisé en ce que**
la valeur de prédiction fait partie d'une courbe de prédiction qui est déterminée et en fonction de laquelle la commande ou la régulation (S5) est effectuée, et la courbe de prédiction est une courbe temporelle d'une tension électrique, d'un état de charge, d'une température, d'un potentiel d'électrode, d'une résistance interne ou d'une pression interne de l'accumulateur d'énergie (1).

10. Procédé selon l'une des revendications précédentes,
**caractérisé en ce que**
lors de la réduction de la puissance délivrée de l'accumulateur d'énergie (1), la tension de sortie ou l'intensité de courant de sortie de l'accumulateur d'énergie est réduite par un système de gestion d'énergie (3) de l'accumulateur d'énergie (1) lui-même.

11. Procédé selon l'une des revendications 1 à 9,
**caractérisé en ce que**
la fin déterminée de la durée de marche restante est transmise à l'outil électrique et la réduction de la puissance délivrée de l'accumulateur d'énergie (1) est obtenue de manière commandée par l'outil électrique par réduction de la consommation électrique de l'outil électrique.

12. Système de gestion d'énergie (3) destiné à un accumulateur d'énergie (1) d'un outil électrique, ledit système comprenant
- un dispositif de mesure (6) destiné à mesurer un vecteur d'état unidimensionnel ou multidimensionnel de l'accumulateur d'énergie (1) et à mesurer une valeur de consommation par rapport à une puissance délivrée de l'accumulateur d'énergie (1),
- un dispositif de calcul (4) destiné à déterminer une valeur de prédiction pour l'outil électrique ou l'accumulateur d'énergie (1) à partir du vecteur d'état et de la valeur de consommation à l'aide d'un modèle et
- un dispositif de commande (5) destiné à commander ou réguler l'outil électrique ou l'accumulateur d'énergie (1) en fonction de la valeur de prédiction,
**caractérisé en ce que**
- la valeur de prédiction inclut une fin de durée de marche restante et
- le dispositif de commande est conçu pour réduire la puissance délivrée de l'accumulateur d'énergie (1) lors de la commande (S5) dès qu'une différence de temps entre un instant actuel et la fin de durée de marche restante tombe au-dessous d'une valeur seuil spécifiée.

13. Accumulateur d'énergie (1) comprenant un système de gestion d'énergie (3) selon la revendication 12.

14. Outil électrique comprenant un accumulateur d'énergie (1) selon la revendication 13.
